# EUROPEAN PATENT APPLICATION

(11) **EP 0 964 514 A1**
(43) Date of publication of application: **15.12.1999**
(21) Application number: 99304081.5
(22) Date of filing: 26.05.1999
(51) Int. Cl.: H03J 1/00

(54) **Radio receiver using location-determining information**

(30) Priority: 11.06.1998 US 95824
(71) Applicant: LUCENT TECHNOLOGIES INC., Murray Hill, New Jersey 07974-0636 (US)
(72) Inventor: McLellan, Scott Wayne, Kempton, Pennsylvania 19529 (US)
(74) Representative: Buckley, Christopher Simon Thirsk

(57) **Abstract**

A radio receiver is disclosed that utilizes location-determining information (using GPS, for example) in conjunction with a database of radio formats and frequencies to maintain a consistent "radio format" as the receiver travels across several different geographic regions. The receiver may be used in a car and is thus capable of maintaining the same radio station format (e.g., "Top 40") as the car is driven long distances.

## Description

### Background of the Invention

The present invention relates to a radio receiver and, more particularly, to a radio receiver including a location-determining system that functions, in association with a local database of radio stations, to control the station selection of the radio receiver.

In most conventional AM/FM radio receivers installed in vehicles, the user/driver must scan through the spectrum to find a particular station of interest (for example, "talk radio", "sports, "NPR", "family radio", etc.). Once a set of favorite stations has been found, the frequencies associated with these stations may be pre-set into the radio receiver. However, when traveling out of the local area, or when traveling in a rental car in an unknown area, it may be difficult to find a station of the particular format that one prefers. The ability to continuously listen to a preferred radio format as one travels from one geographic area to another without having to manually search for a station is a desirable goal.

### Summary of the Invention

The need remaining in the art is addressed by the present invention, which relates to a radio receiver and, more particularly, to a radio receiver including a location-determining system that functions, in association with a local database of radio stations, to control the station selection of the radio receiver.

In accordance with the present invention, a radio receiver is designed to include a location-determining system, such as a Global Positioning System (GPS), as is used by some rental car agencies. A system such as GPS is capable of providing (and constantly updating) information associated with the location of the car (and therefore, the radio receiver). Also included with the radio receiver of the present invention is a database of various radio formats (e.g., "Top 40", "NPR", "Oldies", "News", "Talk radio", etc.) and the frequency(ies) of stations playing those formats for various locations. Therefore, as the car travels from location A to location B, the GPS system will update the "location" information and the database will update the radio frequency for the selected format from that associated with location A to that of location B. For example, if one were driving from Los Angeles to San Diego and wanted to listen to "talk radio", the arrangement of the present invention would constantly update the location information and progressively switch the radio frequency to maintain a station with "talk" format for the entire length of the drive.

It is an aspect of the present invention that many different "location-determining" systems may be used to control the frequency setting of the radio receiver. For example, signal strength could be used to determine when to switch from one location to another. Alternatively, if a radio station's "signal contour" is known, this information may be used. A noise measurement may also be used to determine when to switch from one radio station to another. In general, any of these techniques, or a combination of these techniques, may be used.

If there exists more than one radio station in a certain geographic area that broadcasts the same format, the system of the present invention may be controlled to define a "default" setting. In certain commercial arrangements, such as with a rental car agency, a radio station may pay a fee to the agency to be designated as the "default" station.

Other and further features and advantages of the present invention will become apparent during the course of the following discussion and by reference to the accompanying drawings.

### Brief Description of the Drawings

Referring now to the drawings:
FIG. 1 illustrates an exemplary environment suitable for using the location-controlled radio receiver of the present invention;
FIG. 2 is an exemplary database arrangement that may be used with the radio receiver of the present invention;
FIG. 3 illustrates an exemplary vehicular embodiment of the present invention;
FIG. 4 is a flowchart illustrating the process of the present invention;
FIG. 5 shows an exemplary radio display useful with the location-controlled radio receiver of the present invention.

### Detailed Description

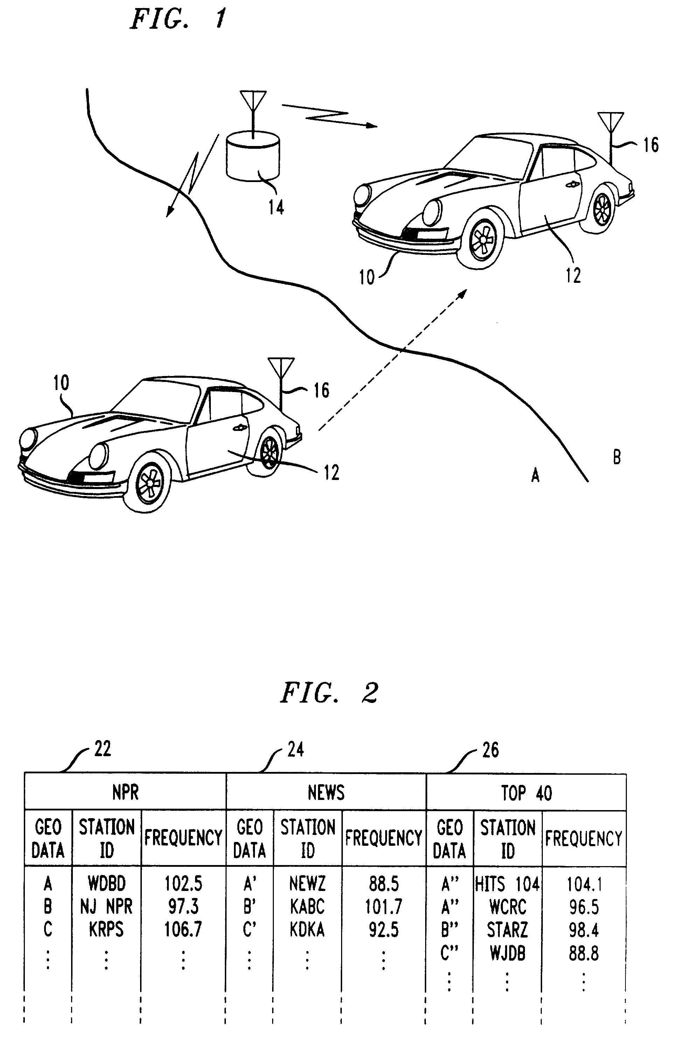

FIG. 1 illustrates an exemplary situation where the location-controlled radio receiver of the present invention may be used. As shown, a vehicle 10 is traveling through region A. Vehicle 10 includes a location-determining receiver 12 where, in this particular embodiment, the location is determined by receiver 12 using information is transmitted by a GPS satellite system 14 and received by an antenna 16 on vehicle 10. The location information is then used to control the station setting of the radio. As vehicle 10 moves out of region A and into region B, receiver 12 determines that vehicle 10 is in region B from the data received from GPS satellite 14. The database within receiver 12, as discussed in detail below, will then switch the radio frequency to a station in region B with the same format as that currently being listened to.

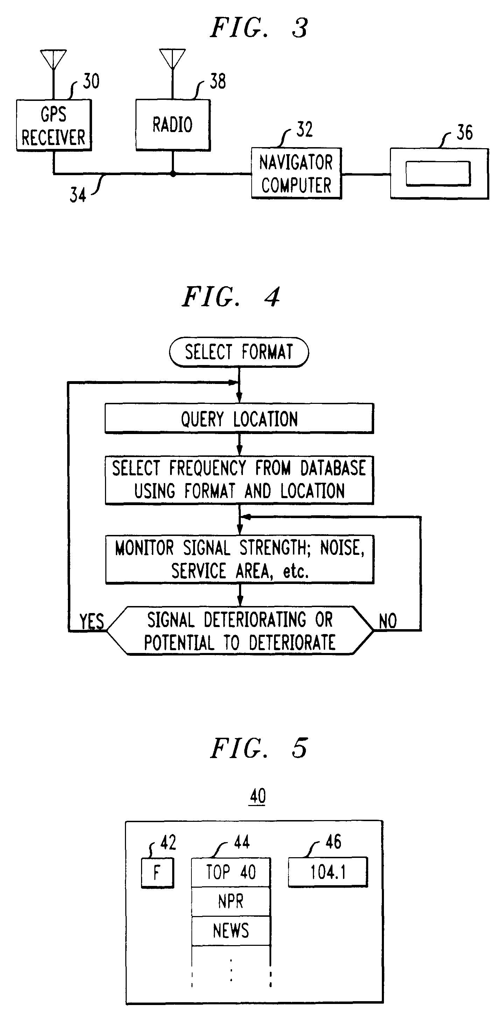

An exemplary database 20 that can be used with receiver 12 to accomplish this automatic tuning function is shown in FIG. 2, where such a database would typically be stored in a navigational computer, such as that shown in FIG. 3. It is to be understood that various other database organizations and formats are possible and all are considered to fall within the scope of the present invention. Referring to FIG. 2, database 20 includes a separate partition for each predetermined format (only a few formats being illustrated for the sake of clarity). For example, a first partition 22 is designated "NPR" and includes the station identification and frequency associated with National Public Radio stations for a number of different geographic locations or areas. The "station identification" may simply be a station's call letters or, alternatively, a promotion slogan used by the station (e.g., "NJ NPR"). The database may be large enough to include nationwide locations, or may be somewhat more localized (e.g., eastern states, Mid Atlantic, Pacific Northwest, etc.). The frequency (or frequencies) associated with NPR for each region are entered into partition 22 of database 20. Similarly, a partition 24 for "news" stations will include the frequencies for such stations in each geographic location. A partition 26 is illustrated as containing "location" and "frequency" information for "top 40" format. In general, each format partition will include the frequencies on a location basis. If there is a region that does not include a station of a particular format, a "not available" indication may be used (for example, all "0"s or all "X"s). While database 20 of FIG. 2 is arranged by "format", it is to be understood that various other database structures are equally suitable, such as organization by geographic area, or even merely an unordered listing of frequency, format and geographic information.

FIG. 3, as mentioned above, illustrates an exemplary vehicular system capable of implementing the invention. Here, a GPS receiver 30 (which is in communication with a GPS satellite, such as satellite 14 of FIG. 1) provides latitude/longitude information to an on-board navigation computer 32 via an exemplary communication bus 34. Navigation computer 32 drives a display 36 and controls a radio receiver 38. An exemplary display is discussed below in association with FIG. 5. Alternatively, GPS receiver 30 and navigational computer 32 may be combined, or bus 34 replaced with direct (i.e., unit-to-unit) connections.

FIG. 4 is a basic flow chart of the process used to maintain the desired radio station format as the radio receiver changes its geographic location. To initiate the system, a desired "Format" is selected. The radio then determines its current location, using a system such as the GPS system discussed above. The "format" and "location" information are then used as pointers into the database (such as database 20 of FIG. 2) to determine the proper radio frequency. As the vehicle travels, the reception of the selected station is monitored. When the signal changes by a predetermined amount (for example, when the signal strength drops a predetermined amount, the noise reaches a predetermined level), the vehicle traverses a signal contour, or any other suitable "signal change" parameter (such as the driver deciding to "re-query" the database to select another format), the location information is again queried and, if necessary, the frequency is switched.

Database 20 may be configured to include a set of "default" settings for a particular format/location when there is more than one local station broadcasting a particular format. For example, for a given location, there may be a set of three different stations that are defined as "talk radio". One station may enter into a commercial arrangement with the provider of the radio receiver to have that frequency identified as the "default" station for that location. This aspect of the present invention is denoted in FIG. 2 by illustrating the "default" station in bold typeset. It is to be understood that the receiver may still capable of tuning in the remaining stations, but the user would need to manually select one of the other stations.

FIG. 5 illustrates an exemplary display for a radio receiver of the present invention. As shown, display 40 includes a "format" button 42 (which may be adjacent to the receiver or as part of a separate display) that may be depressed until the desired format appears on window 44. The "local" frequency associated with that format will be shown on window 46. As the vehicle moves out of region A and into, for example, region B, the frequency would be switched from 104.1 MHz to 98.9 MHz to maintain the "Top 40" format, using the exemplary database values shown in FIG. 2. Alternatively, a menu of stations and formats may be displayed on a screen (such as a moving map display) and the desired station selected therefrom by touch or cursor selection.

As mentioned above, there are many different arrangements that may be used to assess the signal quality and determined the proper time to switch frequencies. For example, the signal "contour" for a particular station may be known. This geographical information, which describes the service area of the station, may also be entered into the database as geographic data and used as the triggering event to switch stations. Other location determining apparatus and methods can be used, such as LORAN (Long Range Navigation), GLONASS (an alternative GPS system) or cellular telephone locating systems. Alternatively, the signal strength and/or presence of noise in the signal may be monitored and used to determine the proper time to switch stations. Various other arrangements may be used (for example, the system may be used with AM radio stations and/or CD radio as well as with the FM stations discussed above) and are all considered to fall within the spirit and scope of the present invention as defined by the claims appended hereto.

## Claims

1. A location-controlled radio receiver comprising
a location-determining system for ascertaining and updating the current location of said radio receiver;
a radio station database listing including radio station formats, frequencies and geographic information for the radio stations; and
a frequency tuner responsive to said database for tuning said radio receiver to a frequency for a selected radio format as a function of the current location of said radio receiver, said tuner for updating the frequency selection as the location of the receiver changes.

2. A location-controlled radio receiver as defined in claim 1 wherein the radio station database includes a plurality of partitions, each partition associated with a different radio station format and including radio frequencies in different geographic locations associated with that format.

3. A location-controlled radio receiver as defined in claim 1 wherein the radio station database includes a plurality of partitions, each partition associated with a different geographic location and including radio frequencies for each format associated with that geographic location.

4. A location-controlled radio receiver as defined in claim 1 wherein the location-determining system comprises a Global Positioning System.

5. A location-controlled radio receiver as defined in claim 1 wherein the frequency tuner includes a signal monitoring system for assessing a received radio signal and updating the frequency selection when the received signal conditions change by a predetermined amount.

6. A location-controlled radio receiver as defined in claim 5 wherein the signal conditions include the geographic contour of the radio station.

7. A location-controlled radio receiver as defined in claim 5 wherein the signal conditions include a power assessment of the received signal.

8. A location-controlled radio receiver as defined in claim 5 wherein the signal conditions include an assessment of a noise signal within the received signal.

9. A location-controlled radio receiver as defined in claim 1 wherein the database is configured to define a default setting for a selected format frequency for at least one geographic location.

10. A method of continuously updating frequency selection of a radio receiver to maintain a predetermined format selection, the method comprising the steps of:
a) selecting a desired radio format;
b) determining the current location of said radio receiver;
c) querying a database within said radio receiver including frequency information for a plurality of formats as a function of location, the query including both the format and location information;
d) obtaining from said database a desired radio frequency for the determined format and location;
e) tuning the radio receiver to the frequency obtained in step d); and
f) repeating steps b) - e) to continuously update the selected frequency.

11. The method as defined in claim 10 wherein the method comprises the further steps of:
g) monitoring conditions of said signal tuned in step e); and
h) returning to step b) when the conditions monitored in step g) reach a predetermined level.

12. The method as defined in claim 11 wherein in performing step g), the signal power is monitored.

13. The method as defined in claim 11 wherein in performing step g), the signal noise level is monitored.

14. The method as defined in claim 11 wherein in performing step g), the location of the receiver with respect to the radio station geographic contour is monitored.
